# EUROPEAN PATENT APPLICATION

(11) **EP 2 159 854 A1**
(43) Date of publication of application: **03.03.2010**
(21) Application number: 08765309.3
(22) Date of filing: 03.06.2008
(51) Int. Cl.: H01L 35/06, H01L 35/32, H02N 11/00

(54) **THERMOELECTRIC CONVERSION MODULE**

(30) Priority: 07.06.2007 JP 2007151838
(71) Applicant: Sumitomo Chemical Company, Limited, Tokyo 104-8260 (JP)
(72) Inventor: HIROYAMA, Yuichi, Tsukuba-shi Ibaraki 300-2617 (JP)
(74) Representative: Hart-Davis, Jason
(86) International application number: PCT/JP2008/060508
(87) International publication number: WO 2008/150004

(57) **Abstract**

The present invention provides a thermoelectric conversion module. The thermoelectric conversion module comprises a plurality of thermoelectric devices and an electrode for electrically connecting the thermoelectric devices in series, wherein the electrode has a hole section opened to the outside of the electrode and metal which is in liquid state within the used temperature range is stored in the hole section.

## Description

### TECHNICAL FIELD

The present invention relates to a thermoelectric conversion module.

### BACKGROUND ART

As conventional thermoelectric conversion modules, known are those having a plurality of thermoelectric devices and an electrode for mutual connection of these thermoelectric devices in which the electrical connection of the thermoelectric devices and the electrode is carried out with liquid metal and the thermoelectric devices and the electrode are disposed so that they can relatively move (e.g., JP-A-2001-24242).

### DISCLOSURE OF THE INVENTION

However, in the above-described thermoelectric conversion module described in patent document 1, electrical connection of the thermoelectric devices and the electrode is attained with liquid metal having flowability, thus, within the used temperature range of relatively high temperature, the liquid metal expands and the liquid metal flows out from between the thermoelectric devices and the electrode. A thermoelectric conversion performance lowers and the stability over time of the thermoelectric conversion performance cannot be sufficient.

Then, the present invention has been made in view of such conditions and has an object of providing a thermoelectric conversion module which is capable of reducing the outflow of liquid metal from between the thermoelectric devices and the electrode, thereby reducing the deterioration of the thermoelectric conversion performance.

The thermoelectric conversion module of the present invention comprises a plurality of thermoelectric devices and an electrode for electrically connecting the thermoelectric devices in series. The electrode has a hole section opened to the outside of the electrode, and metal is stored in the hole section.

According to the thermoelectric conversion module of the present invention, the electrode is provided with a hole section opened to the outside of the electrode, and metal which is in liquid state within the used temperature range is stored in the hole section. In use thereof, the liquid metal expands and flows out in necessary amount from the hole section into a gap between the electrode and thermoelectric devices, thus, electrical connection between the thermoelectric devices and the electrode through the liquid metal can be attained. Therefore, the outflow of the liquid metal from between the thermoelectric devices and the electrode can be reduced and the deterioration of the thermoelectric conversion performance can be reduced. Further, the electrode and the thermoelectric devices are electrically connected so that they can move relatively within the used temperature range. Consequently, a stress due to thermal expansion and shrinkage does not occur easily at a connection part of the electrode and the thermoelectric devices under use environments of relatively high temperature, thus, crack occurrence or the like at the connection part can be reduced.

In the thermoelectric conversion module of the present invention, it is preferable that the hole section is disposed at a position facing the thermoelectric device and opened to the thermoelectric device. The liquid metal flows out efficiently between the electrode and the thermoelectric device, and the electrical connection is tighter and the outflow of a superfluous portion of the liquid metal can be further reduced.

In the thermoelectric conversion module of the present invention, it is preferable that the hole section is formed by rendering at least a part of the electrode porous. It is also permissible that the hole section is formed by rendering at least a part of the electrode mesh-form, or the hole section is formed by providing at least one through hole at the connection position of the electrode. In all embodiments metal which is in liquid state in use can be stored in sufficient amount, thus, electrical connection at the used temperature can be suitably attained.

In the thermoelectric conversion module of the present invention, it is preferable that the electrode is formed from metal composed of, as a main component, at least one selected from the group consisting of titanium, vanadium, chromium, manganese, iron, cobalt, nickel, copper, molybdenum, silver, palladium, gold, tungsten and aluminum. The heat resistance, corrosion resistance and adhesion to a thermoelectric device of the electrode can be improved.

In the thermoelectric conversion module of the present invention, it is preferable that the metal which is in liquid state at the used temperature is metal containing gallium and indium. Since the metal is liquid even around ambient temperature, the outflow of the liquid metal from between the thermoelectric devices and the electrode can be further reduced and the deterioration of the thermoelectric conversion performance can be reduced in a thermoelectric conversion module to be used within the used temperature range of relatively low temperature.

In the thermoelectric conversion module of the present invention, it is preferable that the metal which is in liquid state at the used temperature is a solder composed of, as a main component, at least one selected from the group consisting of gold, silver, tin, lead, zinc, copper and bismuth. The solder is liquid at relatively high temperatures (for example, not lower than 300°C), while solid at relatively low temperatures (for example, not higher than 250°C). As a result, the outflow of the liquid metal from between the thermoelectric devices and the electrode can be further reduced and the deterioration of the thermoelectric conversion performance can be reduced in a thermoelectric conversion module to be used within the used temperature range of relatively high temperature.

Further, for the thermoelectric devices, it is preferable that a metal film is formed on the surface of the connecting side to the electrode. The wettability of the liquid metal to the thermoelectric device is improved, thus, the thermoelectric device and the electrode are electrically connected more tightly.

### BRIEF EXPLANATION OF DRAWINGS

Fig. 1 is a cutaway side view showing a thermoelectric conversion module as one embodiment of the present invention.
Fig. 2 is a partial cross-sectional view showing a second electrode in the thermoelectric conversion module shown in Fig. 1.
Fig. 3 is a perspective view showing variations of an electrode in the thermoelectric conversion module according to the present invention.
Fig. 4 is a perspective view showing variations of an electrode in the thermoelectric conversion module according to the present invention.
Fig. 5 is a partial cross-sectional view showing variations in the connection condition of a thermoelectric device and a second electrode in the thermoelectric conversion module according to the present invention.

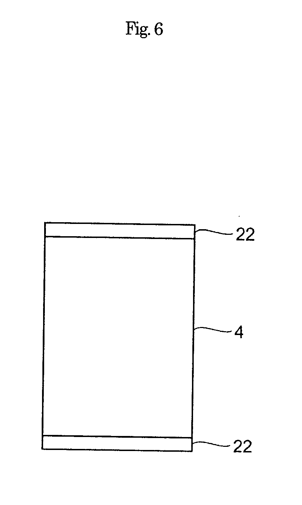

Fig. 6 is a side view showing another embodiment of a thermoelectric device in a thermoelectric conversion module according to the present invention.

### EXPLANATION OF SYMBOLS

1 thermoelectric conversion module
2 first substrate
3 first electrode
4 thermoelectric device
6 second electrode
7 second substrate
8 hole section
9 liquid metal
22 metal film

### MODES FOR CARRYING OUT THE INVENTION

The finding of the present invention can be understood easily by considering the following detailed descriptions referring to appended figures shown only for examples. Embodiments of the present invention will be described referring to appended figures. If possible, the same mark is used for the same element, and duplicated explanations are omitted.

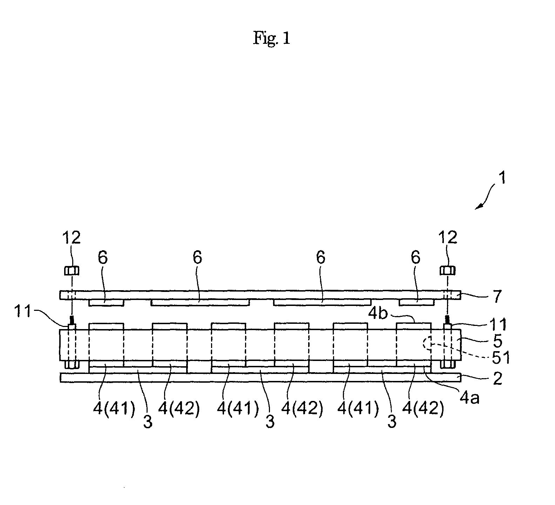

Fig. 1 is a cutaway side view showing a thermoelectric conversion module as one embodiment of the present invention. As shown in Fig. 1, thermoelectric conversion module 1 has a first substrate 2, a first electrode 3, a thermoelectric device 4, a holder 5, a second electrode 6 and a second substrate 7. In the thermoelectric conversion module 1, the side of the first substrate 2 is a relatively lower temperature side and the side of the second substrate 7 is a relatively higher temperature side.

The first substrate 2 has a rectangular shape, and has an electric insulation property and thermal conductivity, and covers one end of the thermoelectric device 4. Examples of the material of the first substrate include alumina, aluminum nitride, and magnesia.

The first electrode 3 is provided on the first substrate 2, and mutually electrically connects one-end surfaces 4a of mutually adjacent thermoelectric devices 4. The first electrode 3 can be formed on a prescribed position on the first substrate 2 using, for example, a thin film technology such as sputtering, and vapor deposition, or a method such as screen printing, and plating. A metal plate having a prescribed shape and the like may also be connected onto the first substrate 2 by soldering and the like. The material of the first electrode 3 is not particularly restricted provided that it has electric conductivity, and preferable is metal containing as a main component at least one selected from the group consisting of titanium, vanadium, chromium, manganese, iron, cobalt, nickel, copper, molybdenum, silver, palladium, gold, tungsten and aluminum to improve the heat resistance, corrosion resistance and adhesion to a thermoelectric device of the electrode. The main component means a component contained in a proportion of not less than 50% by volume in the material of the electrode.

The thermoelectric device 4 is a rod-shaped member having a rectangular cross-section, and includes a p-type thermoelectric device 41 and an n-type thermoelectric device 42. The p-type thermoelectric device 41 and the n-type thermoelectric device 42 are disposed side by side alternately, and fixed by, for example, soldering onto the corresponding first electrode.

Examples of the material of the p-type thermoelectric device include metal mixed oxides such as Ca₃Co₄O₉, and NaₓCoO₂, silicides such as MnSi_{1.73}, Fe₁₋ₓMnₓSi₂, Si_{0.8}Ge_{0.2}, and β-FeSi₂, skutterudites such as CoSb₃, FeSb₃, and RFe₃CoSb₁₂ (R represents La, Ce or Yb), Te-containing alloys such as BiTeSb, and PbTeSb. Examples of the material of the n-type thermoelectric device include metal mixed oxides such as SrTiO₃, Zn₁₋ₓAlₓO, CaMnO₃, LaNiO₃, BaₓTi₈O₁₆, and Ti₁₋ₓNbₓO, silicides such as Mg₂Si, Fe₁₋ₓCoₓSi₂, Si_{0.8}Ge_{0.2}, and β-FeSi₂, skutterudites, clathrate compounds such as Ba₈Al₁₂Si₃₀, and Ba₈Al₁₂Ge₃₀, boron compounds such as CaB₆, SrB₆, BaB₆, and CeB₆, Te-containing alloys such as BiTeSb, and PbTeSb. Of them, thermoelectric devices made of a metal mixed oxide are preferable from the standpoint of production cost and stability in air, and a combination of Ca₃CO₄O₉ as the p-type thermoelectric device and CaMnO₃ as the n-type thermoelectric device is particularly preferable. The thermoelectric devices can be suitably used in a power generator which utilizes a heat source of particularly high temperature since the devices have a high thermoelectric property particularly at about 700 to 800°C. More specifically, the suitably used temperature range is, for example, 300 to 570 K for the BiTe, 300 to 850 K for the PbTe, 500 to 800 K for the silicide such as MnSi, and MgSi, 500 to 750 K for the ZnSb, 300 to 900 K for the CoSb (skutterudite), and about 500-1100 K for the oxide.

The holder 5 has a thermal insulation property and electric insulation property and supports the thermoelectric devices 4. The holder 5 is provided with rectangular through holes 51 formed corresponding to the cross-sectional form of the thermoelectric device, at positions corresponding to the disposal of the thermoelectric device 4, and each thermoelectric device 4 is inserted in the through hole 51. Between the inner wall surface of the through hole 51 and the side surface of the thermoelectric device 4, for example, an inorganic adhesive or the like is filled, and the thermoelectric device 4 is supported by the holder 5.

The material of the holder 5 is not particularly restricted provided that it has a thermal insulation property and electrical insulation property, and for example, ceramic materials and the like can be used. As the ceramic material, preferable are oxides which are sintered at prescribed temperature and having a high insulation property, and examples thereof include silicon oxide, calcium oxide, aluminum oxide, magnesium oxide, zirconium oxide, cerium oxide, mullite, and cordierite. Each of these oxides may be used singly or in combination with another or more. Further, the ceramic material may contain a glass frit, if necessary.

The second electrode 6 electrically connects mutually another-end surfaces 4b of mutually adjacent thermoelectric devices 4. The thermoelectric devices 4 are connected electrically serially by the second electrode 6 and the first electrode 3 provided on the side of one end surface 4a of the thermoelectric device 4.

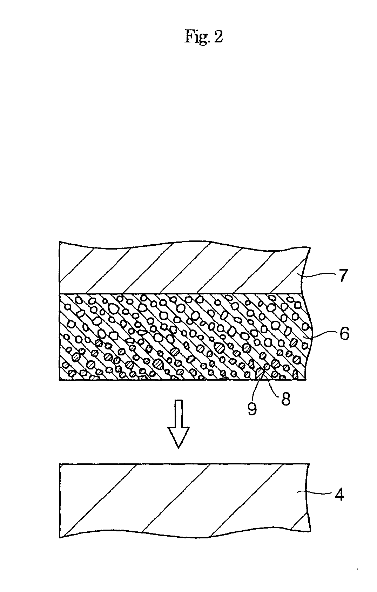

Fig. 2 is a partial cross-sectional view of the second electrode 6. As shown in Fig. 2, the second electrode 6 is provided with a hole section 8 opened to its surface, at a position of connection to the thermoelectric device 4. It is preferable that the hole section 8 has an opening on the surface of the second electrode 6 facing the thermoelectric device 4. Liquid metal described later flows out efficiently between the second electrode 6 and the thermoelectric device 4, thus, the electrical connection is tighter. The hole section 8 can be formed by, for example, rendering the second electrode 6 porous.

The porous electrode 6 can be fabricated by, for example, a method described below. First, a water-insoluble hydrocarbon organic solvent having about 5 to 8 carbon atoms, a surfactant, a water-soluble resin binder, a metal powder and water are mixed in prescribed amounts to prepare a metal paste. Using the metal paste, a formed body of a prescribed shape is formed by a conventional method such as a doctor blade. The formed body is kept at a temperature, for example, of not lower than 5°C. Thus, the water-insoluble hydrocarbon organic solvent vaporizes and is evaporated from the formed body, thereby forming a porous formed body containing fine bubbles generated in the formed body. Further, the porous formed body is sintered to obtain a porous electrode. The hole section 8 can be formed easily by thus rendering the second electrode 6 porous.

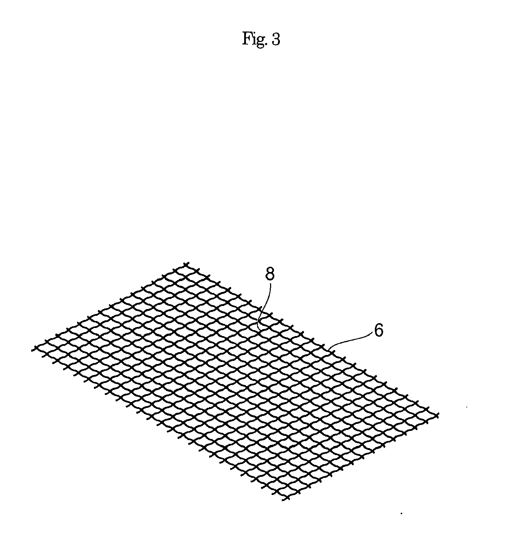

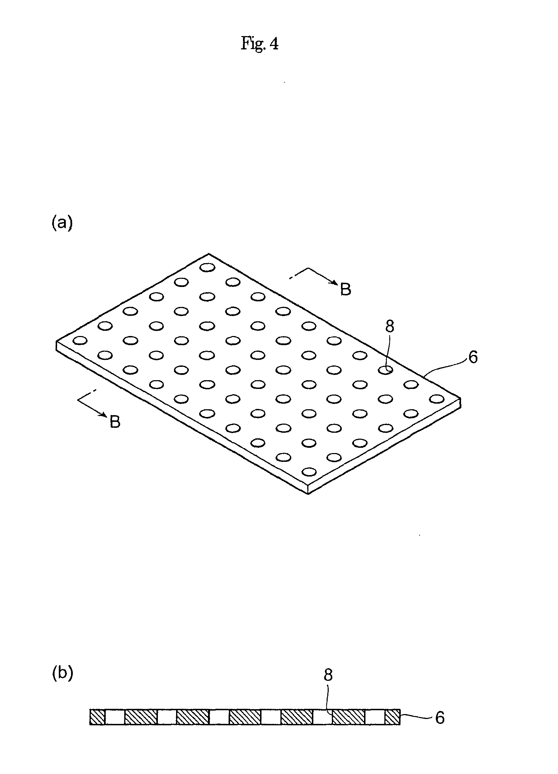

The hole section 8 of the second electrode 6 is not limited to those formed by rendering the electrode porous. Fig. 3 and Fig. 4 are views showing an embodiment of the second electrode 6. As shown in Fig. 3, it may be a hole section formed by rendering the electrode mesh-form, or as shown in Fig. 4(a) and Fig. 4(b) as a B-B sectional view of (a), it may be a hole section formed by providing a through hole in the electrode. In all embodiments the hole section 8 can be formed easily.

Though the material of the second electrode 6 is not particularly restricted provided that it has electric conductivity and it is not melted within the used temperature range, preferable is metal containing as a main component at least one selected from the group consisting of titanium, vanadium, chromium, manganese, iron, cobalt, nickel, copper, molybdenum, silver, palladium, gold, tungsten and aluminum to improve the heat resistance, corrosion resistance and adhesion to a thermoelectric device of the electrode.

The second electrode 6 has one surface side which is fixed by solder and the like onto the second substrate 7 on the side of the thermoelectric device 4. In contrast, it has another surface side which is not fixed by solder and the like onto the other end surface 4b of the thermoelectric device 4, and the second electrode 6 and the thermoelectric device 4 are in contact so that they can relatively move. Specifically, as shown in Fig. 1, the second substrate 7 to which the second electrode 6 is fixed, and the holder 5 are fixed by bolts 11 and nuts 12. In the fixing, the tightening torque of the bolt 11 or the nut 12 is regulated so as to give pressure under which the second electrode 6 and the thermoelectric device 4 can relatively move. The second substrate 7 has a rectangular shape and covers the other end side of the thermoelectric device 4. The second substrate 7 is not particularly restricted provided that it has an electrical insulation property and has thermal conductivity like the first substrate 2, and materials such as alumina, aluminum nitride, and magnesia can be used.

In the hole section 8 of the second electrode 6, metal 9 which is in liquid state within the used temperature range of the thermoelectric conversion module is stored. The metal 9 which is in liquid state within the used temperature range is not required to be stored in all pore sections 8, and it may advantageously be stored at least in pore sections 8 opened to the surface of the electrode. The liquid metal 9 is not particularly restricted provided that it is metal which is in liquid state within the used temperature range, particularly, within the used temperature range of the relatively higher side (for example, about 500 to 800°C). As the metal 9 which is in liquid state within the used temperature range of the thermoelectric conversion module, metal containing gallium and indium can be used. Since the metal is liquid even around ambient temperature, the outflow of the liquid metal from between the thermoelectric device and the electrode can be further reduced and the deterioration of the thermoelectric conversion performance can be reduced in a thermoelectric conversion module to be used within the used temperature range of relatively low temperature. As the material of the metal 9 which is in liquid state within the used temperature range of the thermoelectric conversion module, a solder composed of, as a main component, at least one selected from the group consisting of gold, silver, tin, lead, zinc, copper and bismuth can be used. The solder is liquid at relatively high temperatures (for example, not lower than 300°C), while solid at relatively low temperatures (for example, not higher than 250°C). As a result, the outflow of the liquid metal from between the thermoelectric device and the electrode can be further reduced and the deterioration of the thermoelectric conversion performance can be reduced in a thermoelectric conversion module to be used within the used temperature range of relatively high temperature.

The method for storing the metal 9 which is in liquid state in the hole section 8 is not particularly restricted, and for example, an electrode may be immersed in the liquid metal 9.

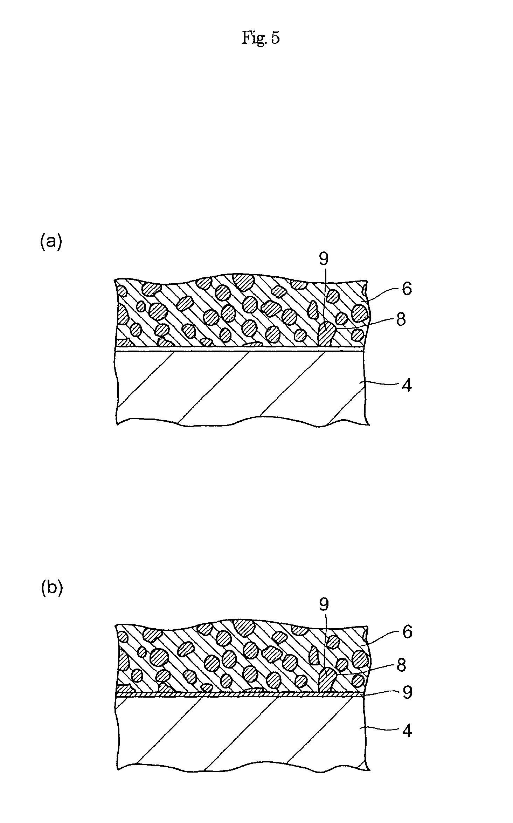

Then, the form of electrical connection of the thermoelectric device 4 and the second electrode 6 through the liquid metal 9 is illustrated. Fig. 5 is a partial cross-sectional view showing variations in the connection condition of the thermoelectric device 4 and the second electrode 6.

Under the lower temperature condition during which the thermoelectric conversion module 1 stops working, the liquid metal 9 is stored in the hole section 8 of the second electrode 6, and the electrical connection between the thermoelectric device 4 and the second electrode 6 is not necessarily sufficient, as shown in Fig. 5(a). Under a condition during which the thermoelectric conversion module 1 works, that is, when the side of the second electrode 6 is exposed to higher temperatures, the liquid metal 9 flows out to the opening side from the hole section 8 owing to thermal expansion, as shown in Fig. 5(b). The flown liquid metal 9 migrates into a gap between the thermoelectric device 4 and the second electrode 6 to form totally or partially a thin film, thereby attaining electrical connection.

As described above, in the thermoelectric conversion module 1, the second electrode 6 is provided with the hole section 8 for storing the metal 9 which is in liquid state within the used temperature range in the second electrode 6. Within the used temperature range, the liquid metal 9 expands and flows out in necessary amount from the hole section 8 into a gap between the second electrode 6 and the thermoelectric device 4, and electrical connection can be attained. Therefore, the outflow of the liquid metal 9 from between the thermoelectric device 4 and the second electrode 6 can be reduced and the deterioration of the thermoelectric conversion performance can be reduced. The second electrode 6 and a plurality of thermoelectric devices 4 are electrically connected so that they can move relatively. A stress due to thermal expansion and shrinkage does not occur easily at a connection part of the second electrode 6 and the thermoelectric devices 4 under use environments of relatively high temperature, and crack occurrence and the like at the connection part can be reduced.

Preferable embodiments of the present invention are described above, but the present invention is not limited to the embodiments.

For example, for the thermoelectric device 4, a metal film 22 may be formed on the surface of the connecting side to the electrode. The wettability of the liquid metal to the thermoelectric device 4 is improved, and the thermoelectric device 4 and the electrodes 3 and 6 are electrically connected more tightly.

The first electrode 4 may have a structure with a hole section 8 for storing metal 9 which is in liquid state, like the second electrode 6. Further, the hole section 8 is not necessarily on the surface facing the thermoelectric device 4, and for example, when the hole section 8 is provided on the side surface of the electrode 6, the leached liquid metal is allowed to move into a gap between the electrode 6 and the thermoelectric device 4 by a capillary phenomenon and the like, and the present invention can be performed.

### INDUSTRIAL APPLICABILITY

Use of the present invention, the outflow of liquid metal from between a thermoelectric device and an electrode can be reduced and the deterioration of the thermoelectric conversion performance can be reduced.

## Claims

1. A thermoelectric conversion module comprising a plurality of thermoelectric devices and an electrode for electrically connecting the thermoelectric devices in series, wherein the electrode has a hole section opened to the outside of the electrode and metal which is in liquid state within the used temperature range is stored in the hole section.

2. The thermoelectric conversion module according to claim 1, wherein the hole section is disposed at a position facing the thermoelectric device and opened to the thermoelectric device.

3. The thermoelectric conversion module according to claim 1 or 2, wherein the hole section is formed by rendering at least a part of the electrode porous.

4. The thermoelectric conversion module according to claim 1 or 2, wherein the hole section is formed by rendering at least a part of the electrode mesh-form.

5. The thermoelectric conversion module according to claim 1 or 2, wherein the hole section is formed by providing at least one through hole in the electrode.

6. The thermoelectric conversion module according to any one of claims 1 to 5, wherein the electrode is formed from metal composed of, as a main component, at least one selected from the group consisting of titanium, vanadium, chromium, manganese, iron, cobalt, nickel, copper, molybdenum, silver, palladium, gold, tungsten, and aluminum.

7. The thermoelectric conversion module according to any one of claims 1 to 6, wherein the metal which is in liquid state within the used temperature range is metal containing gallium and indium.

8. The thermoelectric conversion module according to any one of claims 1 to 7, wherein the metal which is in liquid state within the used temperature range is a solder composed of, as a main component, at least one selected from the group consisting of gold, silver, tin, lead, zinc, copper, and bismuth.

9. The thermoelectric conversion module according to any one of claims 1 to 8, wherein for the thermoelectric devices, a metal film is formed on the surface of the connecting side to the electrode.
